# EUROPEAN PATENT APPLICATION

(11) **EP 3 667 923 A1**
(43) Date of publication of application: **17.06.2020**
(21) Application number: 18211744.0
(22) Date of filing: 11.12.2018
(51) Int. Cl.: H03M 1/06, H03M 1/74

(54) **FREQUENCY DAC FOR RADAR**

(71) Applicant: IMEC vzw, 3001 Leuven (BE)
(72) Inventor: SHI, Qixian, 3001 LEUVEN (BE); CRANINCKX, Jan, 3001 LEUVEN (BE); BUNSEN, Keigo, 3001 LEUVEN (BE)
(74) Representative: IP HILLS NV

(57) **Abstract**

Example embodiments describe a frequency digital-to-analogue converter (415), FDAC, for generating an analogue frequency modulating signal (420) from a digital frequency modulating signal (421). The FDAC comprises a Least Significant Bit, LSB, DAC section (440) and a Most Significant Bit, MSB, DAC section (460). The LSB DAC section comprises a plurality of LSB DACs (441-443) and is configured to switch (445) between the LSB DACs for mitigating mismatch. The MSB DAC section (460) comprises a plurality of MSB DAC cells and is configured to switch (474-476) the MSB DAC cells according to a predefined sequence (465) during a period of the digital frequency modulating signal.

## Description

### Technical Field

Various example embodiments relate to a Frequency Digital-to-Analogue Converter, FDAC, a signal generator, a Frequency-Modulated Continuous-Wave, FMCW, radar and related methods.

### Background

A Frequency-Modulated Continuous-Wave radar (FMCW), or sometimes called a Continuous-Wave Frequency-Modulated (CWFM) radar transmits a continuous wave signal that increases or decreases linearly in frequency over a fixed period of time. The signal reflected from an object is then mixed with the transmitted signal to an intermediate frequency, IF, signal from which both speed and distance of the object is derived.

The frequency modulation or frequency output of the radar signal may follow different patterns such as a sawtooth wave or a triangle wave. This frequency modulation of the radar signal is controlled by an analogue frequency modulating signal. The analogue frequency modulating signal, on its turn, is converted by a so-called Frequency Digital-to-Analogue Converter, FDAC, from a digital representation of the frequency modulating signal, i.e., a digital frequency modulating signal.

One possible implementation of an FDAC is by a current DAC that is loaded with a resistor to generate the analogue frequency modulating signal. The current DAC then comprises a Least Significant Bit, LSB, section that provides the least significant portion of the current based on the LSBs of the digital frequency modulating signal and a Most Significant Bit, MSB, section that provides the most significant portion of the current based on the MSBs of the digital frequency modulating signal.

An important aspect of an FDAC is its linearity because it influences the Spurious Free Dynamic Range, SFDR, of the IF signal. Such spurs may, on their turn, trigger a false target alert by the FMCW radar.

### Summary

Amongst others, it is an object of embodiments of the invention to alleviate the above SFDR problem with FDACs and to provide a solution that contributes to an IF radar signal with an improved SFDR thereby causing less false target alerts.

This object is achieved, according to a first example aspect of the present disclosure, by a frequency digital-to-analogue converter, FDAC, for generating an analogue frequency modulating signal from a digital frequency modulating signal. The FDAC comprises a Least Significant Bit, LSB, DAC section and a Most Significant Bit, MSB, DAC section. The LSB DAC section comprises a plurality of LSB DACs and is configured to switch between the LSB DACs for mitigating mismatch. The MSB DAC section comprises a plurality of MSB DAC cells and is configured to switch the MSB DAC cells according to a predefined sequence during a period of the digital frequency modulating signal.

Mismatch of components in an FDAC contributes to the non-linearity of the FDAC. Mismatch may be mitigated by so-called dynamic element matching (DEM) wherein a switching between different instances of a component is performed. The FDAC performs such switching for the LSBs by switching between different instances of LSB DACs. While the LSBs contribute less to the non-linearity in a general purpose DAC, they do contribute significantly to the SFDR of the IF output in a radar system because of the inherent properties of self-mixing used to obtain the IF signal. In such radar systems, different waveforms may be used for the analogue frequency modulating signal, e.g. a sawtooth wave or a triangle wave. Mismatch in the components of the LSB DAC section will cause a repeating pattern in the radar's IF signal and cause spikes in its frequency spectrum.

The MSB DAC cells, each contributing to a portion of the output analogue signal, are further switched according to predefined sequence during a period of the frequency modulating signal, e.g. during a single sawtooth or triangle wave cycle. In other words, during such a period the MSB DAC section activates or deactivates the MSB DAC cells incrementally according to the predefined sequence with respectively increasing or decreasing MSBs. Because of this, the mismatch between the different MSB DAC cells will be expressed as a common mode signal in the transmitted and received signal when used in a radar and, hence, be cancelled out in the IF signal, again improving the SFDR of the IF signal.

The LSB DAC may further comprise a plurality of binary weighted DAC cells in order to limit the number of LSB DAC cells.

According to an embodiment, the FDAC comprises a circuitry configured to randomly select one of the LSB DACs for mitigating the mismatch.

Advantageously, the LSB DAC section performs the switching between the LSB DACs at least once per change of an MSB of the digital frequency modulating signal as this results in an optimal mismatch mitigation.

According to a further embodiment, the MSB DAC section is configured to select different sequences for consecutive periods of the frequency modulating signal. By varying the sequencing in this way, other non-idealities of the MSB DAC section will not occur in the IF signal in a periodic manner thereby further improving the SFDR of the IF signal. The different sequences may be pre-defined and stored in look-up tables. The selection of these pre-defined sequences may then be performed in a random or pseudo-random manner.

Advantageously, the MSBs of the digital frequency modulating signal are thermometer coded.

According to a second aspect, the invention relates to a signal generator for generating a Frequency-Modulated Continuous-Wave, FMCW, radar signal comprising: i) an FDAC according to the first aspect for generating an analogue frequency modulating signal; and ii) an oscillator controlled by the analogue frequency modulating signal configured to generate the Frequency-Modulated Continuous-Wave, FMCW, radar signal.

The signal generator may further comprise a circuitry for generating the digital frequency modulating signal.

According to a third aspect, the invention relates to a continuous-wave radar comprising an FDAC according to the first aspect or a signal generator according to the second aspect.

According to a fourth aspect, the invention relates to a method for generating an analogue frequency modulating signal from a digital frequency modulating signal comprising the following steps: i) converting Least Significant Bits, LSBs, of the digital frequency modulating signal by one of a plurality of LSB DACs; ii) switching between the LSB DACs for mitigating mismatch; iii) converting the Most Significant Bits, MSBs, of the digital frequency modulating signal by MSB DAC cells; and switching the MSB DAC cells according to a predefined sequence during a period of the digital frequency modulating signal.

### Brief Description of the Drawings

Fig. 1 illustrates a functional block diagram of a FMCW radar 100 according to an embodiment of the invention;
Fig. 2 shows a plot of the frequency of a transmitted and received radar signal on the vertical axis as a function of time;
Fig. 3 illustrates a signal generator according to an embodiment of the invention;
Fig. 4 illustrates a frequency analogue to digital converter according to an embodiment of the invention;
Fig. 5 shows a plot of a transmitted analogue frequency modulating radar signal derived from a digital signal comprising one MSB and two LSBs by the FDAC of Fig. 4 when there is no LSB mismatch mitigation applied;
Fig. 6 shows a plot of a transmitted analogue frequency modulating radar signal derived from a digital signal comprising one MSB and two LSBs by the FDAC of Fig. 4 when there is LSB mismatch mitigation applied according to an embodiment of the invention;
Fig. 7 shows a plot 700 of the frequency spectrum of an intermediate frequency signal obtained from a simulated model of the radar according to Fig. 1 to Fig. 4 when mismatch mitigation is applied in both the LSB DAC section and the MSB DAC section; and
Fig. 8 shows a plot of the frequency spectrum of an intermediate frequency signal obtained from a simulated model of the radar according to Fig. 1 to Fig. 4 when no mismatch mitigation is applied in both the LSB DAC section and the MSB DAC.

### Detailed Description of Embodiment(s)

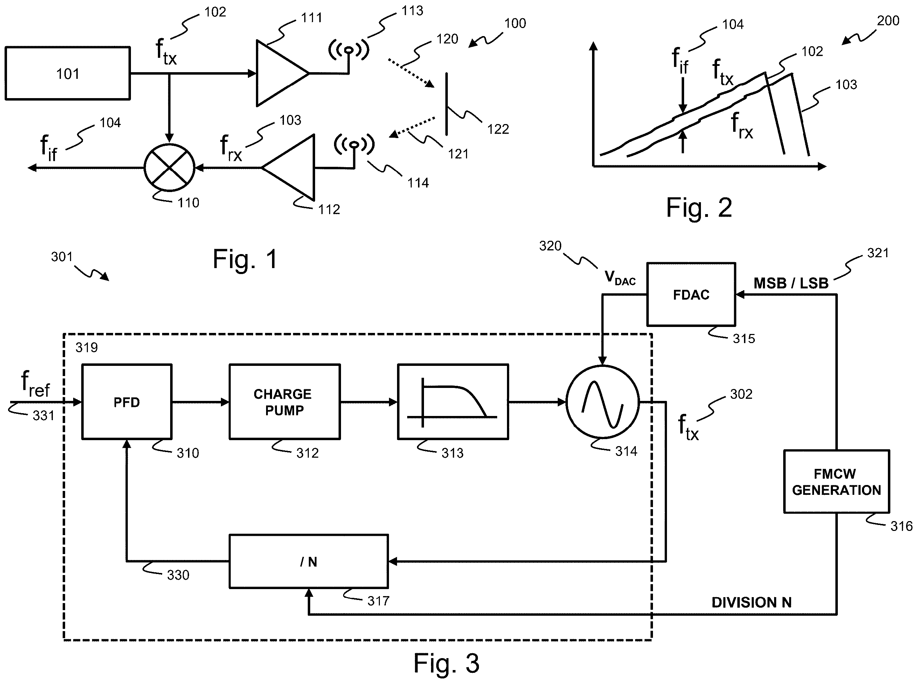

Various example embodiments relate, amongst others, to a Frequency Digital-to-Analogue Converter, FDAC, a signal generator, a Frequency-Modulated Continuous-Wave, FMCW, radar and related methods. Fig. 1 illustrates a functional block diagram of a FMCW radar 100 according to an embodiment of the invention. Radar 100 comprises a signal generator 101 for generating a radar signal 102; a power amplifier 111 for amplifying the radar signal 102 and a transmitting antenna 113 for transmission of the amplified radar signal 102. Upon transmission, the radar signal travels through the air as a wireless signal 120 until encountering an object 122 against which the wireless signal 102 reflects and returns as a reflected radar signal 121. Radar 100 further comprises a receiving antenna 114 for receiving the reflected radar signal 121. The received signal is then amplified by a low noise amplifier, LNA, 112. The resulting intermediate frequency signal 104 is then obtained by mixing the transmitted radar signal 102 with the received radar signal 103 thereby obtaining a difference between the transmitted and reflected signal.

Fig. 2 shows a plot 200 of the frequency of the transmitted and received radar signals 102, 103 on the vertical axis as a function of time, i.e. plot 200 illustrates the frequency modulation of the transmitted and received radar signals or, shortly, the frequency modulating radar signals 102 and 103. The radar signals 102, 103 are not perfectly linear, but exhibit some non-linearity due to non-idealities of the radar components. In Fig. 2, the transmitted frequency modulating signal 102 has a sawtooth wave form, sometimes also referred to as a chirp signal. Also, other waveforms may be used, e.g. a triangular waveform. Fig. 2 shows a single period of the transmitted frequency modulating signal 102. During operation, the signal generator 101 generates a continuously repeated version of this signal 102. As it takes a certain time duration for the radar signal to propagate and reflect through the air, the received signal 103 will be shifted in time with respect to the transmitted signal 102. By the mixing operation 110, the intermediated frequency modulating signal 104 is indicative for the difference between the transmitted and received frequency modulating signals 102 and 103. From the resulting intermediate frequency modulating signal 104, both the distance to and speed of the reflecting object 122 may be obtained.

Fig. 3 illustrates a signal generator 301 according to an embodiment of the invention. An instance of signal generator 301 may be used as signal generator 101 for the radar 100 of Fig. 1. Signal generator 301 comprises an oscillator 319 that generates the radar signal 302 as output. The output frequency of the oscillator is controlled by the analogue frequency modulating signal 320. Signal generator 301 also comprises an FMCW generation circuitry 316 that generates a digital version of the frequency modulating signal. This digital signal 321 is fed into FDAC 315 that converts the digital frequency modulating signal into the analogue frequency modulating signal 320. The oscillator 319 may be implemented by a phase locked loop or, shortly, PLL. PLL 319 comprises a phase comparator or detector 310 that determines the phase difference between a reference signal with constant frequency f_{ref} and a scaled or divided version 330 of the output signal 302. This difference then controls a voltage controlled oscillator, VCO 314, through a charge pump 312 and low pass filter 313. A standalone PLL would then lock the frequency of the output signal 302 to that of the reference signal 331. In PLL 319 on the other hand, the oscillator 314 is also controlled by frequency modulating signal 320 such that the output signal 302 will vary in frequency according to the frequency modulating signal 320. Divider 317 of PLL 319 may further be controlled by the digital signal from FMCW generation circuitry 316 to ensure that the PLL stays in a locked condition during the chirping operation.

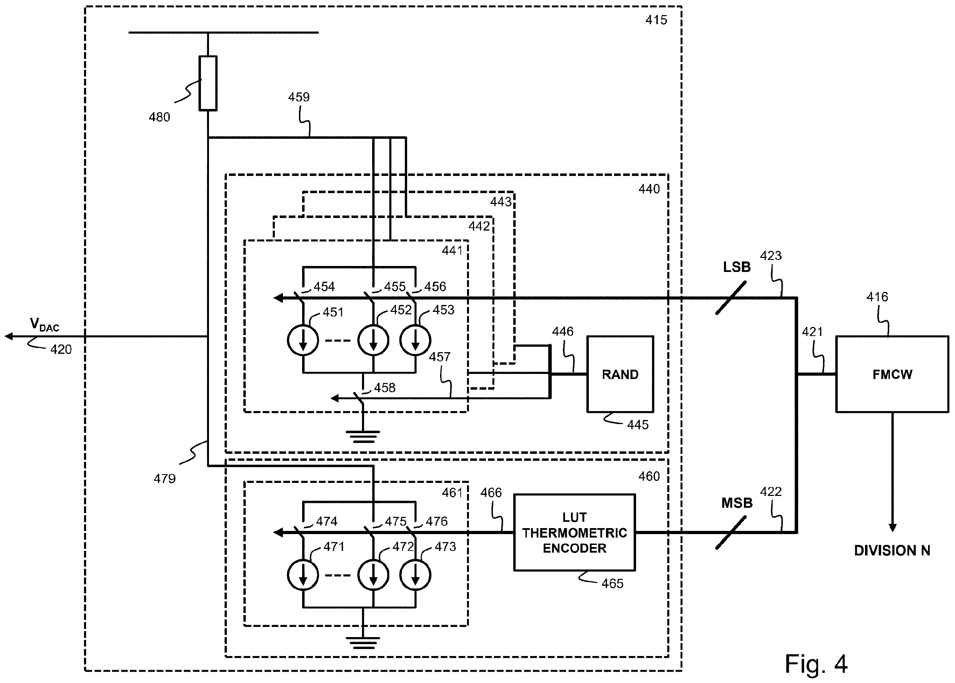

Fig. 4 illustrates an FDAC 415 according to an embodiment of the invention, e.g. for use in radar 100 and/or signal generator 301. FDAC 415 comprises an LSB section 440 and an MSB section 460. LSB section 440 converts the least significant bits, LSBs 423, of the digital frequency modulating signal 421 to an analogue signal portion 459. MSB section 460 converts the most significant bits, MSBs 422, of the digital frequency modulating signal 421 to an analogue signal portion 479. The output analogue frequency modulating signal 420 is then based on the sum of both signal portions 459 and 479. FDAC 415 is a current steering DAC, i.e., signal portions 459 and 479 are represented by currents. FDAC 415 may further comprise a resistor 480 for converting the output current of FDAC 415 to an analogue frequency modulating output voltage 420.

LSB section 440 comprises a plurality of LSB DACs 441-443. An LSB DAC is configured to produce the analogue output signal portion 459 from the digital input LSBs 423. To this respect, LSB DACs 442-443 may be instances of LSB DAC 441. An LSB DAC 441 comprises a plurality of current sources 451-453, i.e. LSB DAC cells. Advantageously, every single current source 451-453 is weighted, more advantageously binary weighted. In such a case, a first current source 451 is configured to generate a current I_{LSB}, a second current source to generate a current 2 x I_{LSB}, a third current source to generate 4 x I_{LSB} etc. More general when having N LSBs, then there are N weighted current sources 451-453 with a respective current 2ⁱ x I_{LSB} for i={1 ...N}. The LSB DAC 441 further comprises switches 454-456 for activating the respective current sources 451-453. When using a binary weighted LSB DAC 441, then the switches may be operated directly by the respective LSBs. LSB section 440 further comprises a selection circuitry 445 for selecting one of the LSB DACs 441-443. The selection may for example be performed at every clock cycle of the FDAC 415 or after any other time period. Advantageously, the selection is performed at least every time when one of the MSBs 422 changes. Selection circuitry 445 may perform the selection in a random or pseudo-random manner. By performing the selection, mismatches between current sources of an LSB DAC are not fixed for each LSB value but averaged out over the different LSB DACs.

MSB section 460 comprises an MSB DAC 461 further comprising a plurality of MSB DAC cells each comprising a current source 471-473 and a switch 474-476. The MSB DAC cells are equally dimensioned, i.e., each current source is configured to deliver the same amount of current I_{MSB}. As the MSB DAC cells are equally weighted, they cannot be controlled directly by the MSBs 422. To this respect MSB section 460 further comprises a thermometric encoder 465 that converts the MSB binary coding to a form of thermometer or unary coding 466. The encoder 465 is further configured to perform the encoding according to a predefined sequence during a period of the digital frequency modulating signal 421. Or, in other words, the encoder 465 is configured such that the MSB DAC cells are activated or deactivated incrementally when presented with respectively increasing or decreasing MSBs. As a result, the MSB DAC cells will not toggle during an increasing or decreasing input signal. The encoder 465 may further comprise a lookup table for storing the predefined sequence.

Advantageously, the encoder 465 comprises a plurality of such lookup tables and, thus, a plurality of the predefined sequences. The MSB section 460 then selects a different sequence during every next period of the frequency modulating input signal 421, for example after each sawtooth or triangle wave cycle. By selecting from a plurality of predefined sequences, mismatches between the different MSB DAC cells are not repeated over each period of the modulating signal but averaged out.

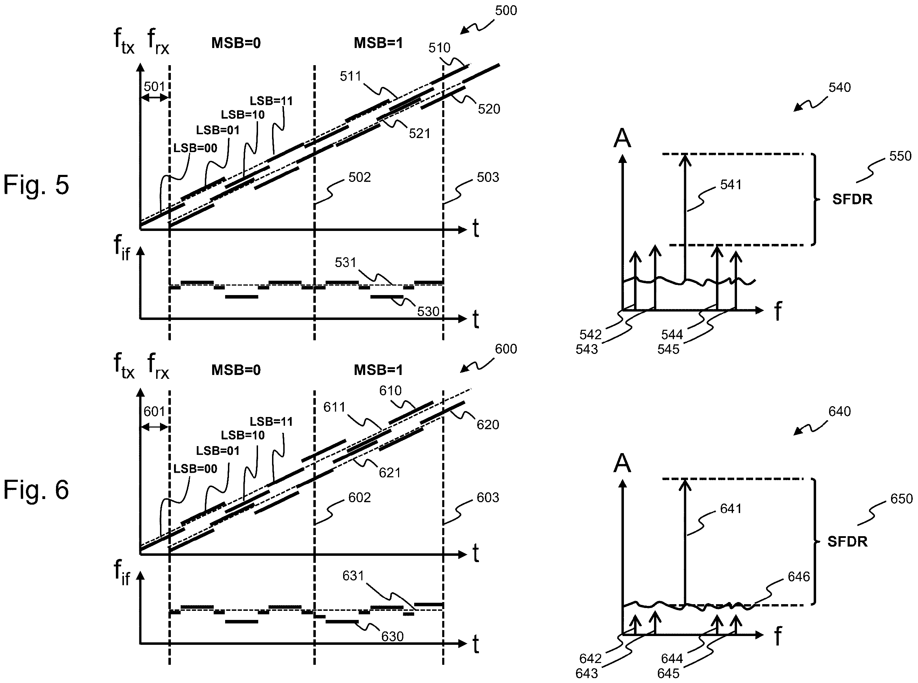

Fig. 5 shows a plot 500 of a transmitted analogue frequency modulating radar signal 510 converted from a digital signal with one MSB and two LSBs by the FDAC 415 but when there is no switching between LSB DACs 441-443 applied, i.e., when there is no LSB mismatch mitigation. In such case, signal 510 will show a different unwanted offset from the ideal ADC conversion signal 511 at each transition of an LSB. Furthermore, this offset pattern will be repeated at each MSB transition 502, 503. The received radar signal 520 will show the same offset pattern from the ideal signal 521 but shifted in time due to the propagation time 501 between the radar and the detected object. The non-idealities of the FDAC 415 will also result in a repeating offset pattern in the intermediate frequency signal 530 with respect to the ideal intermediate frequency signal 531. Plot 540 of Fig. 5 illustrates the frequency spectrum of this intermediate frequency signal 530 comprising the wanted frequency spike 541 but also unwanted spurious frequency spikes 542-545 caused by the repeating offset pattern. Due to these spikes, the spurious free dynamic range 550 of the radar signal is negatively impacted.

Fig. 6 illustrates a plot 600 of a transmitted analogue frequency modulating radar signal 610 derived from a digital signal with one MSB and two LSBs by the FDAC 415 but now when there is a switching between LSB DACs 441-443 applied, i.e., when there is LSB mismatch mitigation performed. In this case, signal 610 will also show a different unwanted offset from the ideal ADC conversion signal 611 at each transition of an LSB. However, this offset pattern will not be repeated at each MSB transition 602, 603. The received radar signal 620 will show the same offset pattern from the ideal signal 621 but shifted in time by the air delay 601 between the radar and the detected object. The non-idealities of the LSB DAC section of FDAC 415 will now result in a non-repeating offset pattern in the intermediate frequency signal 630 with respect to the ideal intermediate frequency signal 631. Plot 640 of Fig. 6 illustrates the frequency spectrum of this intermediate frequency signal 630 comprising the wanted frequency spike 641. Due to the mismatch mitigation, unwanted spurious frequency spikes 642-645 will be spread out under the noise floor 646 of the radar system. This results in a higher SDFR 650 when compared with the SFDR 550 of Fig. 5.

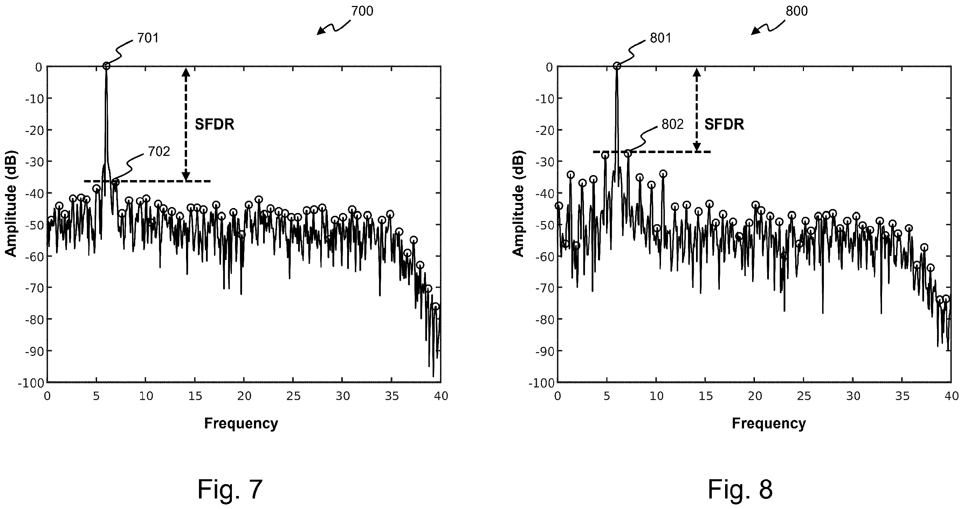

Fig. 7 illustrates a plot 700 of the frequency spectrum of a received intermediate frequency signal 104 obtained from a simulated model of the radar according to Fig. 1 to Fig. 4, i.e., when mismatch mitigation is applied in both the LSB DAC section and the MSB DAC section by the respective selection circuitries 445 and 465. Frequency spike 701 is related to the detected object 122. The distance between this spike 701 and the strongest spurious spike 702 is around 37dB, i.e. the SFDR is around 37dB.

As a comparison, Fig. 8 illustrates a plot 800 of the frequency spectrum of a received intermediate frequency signal 104 obtained from a simulated model of the radar according to Fig. 1 to Fig. 4 but when no mismatch mitigation is applied in both the LSB DAC section and the MSB DAC section by the respective selection circuitries 445 and 465. Frequency spike 801 is related to the detected object 122. The distance between this spike 801 and the strongest spurious spike 802 is around 27dB, i.e. the SFDR is around 27dB. In other words, the mismatch mitigation by the radar according to Fig. 1 to Fig. 4 results in a 10dB improvement of the SFDR.

The FDAC 415 according to the above embodiments is a current DAC, i.e., the digital input signal is converted into currents and, thereupon, converted to a voltage. As an alternative, the same LSB and MSB mismatch mitigation technique may also be applied to a voltage DAC.

As used in this application, the term "circuitry" may refer to one or more or all of the following:
(a) hardware-only circuit implementations such as implementations in only analogue and/or digital circuitry and
(b) combinations of hardware circuits and software, such as (as applicable):
   (i) a combination of analogue and/or digital hardware circuit(s) with software/firmware and
   (ii) any portions of hardware processor(s) with software (including digital signal processor(s)), software, and memory(ies) that work together to cause an apparatus, such as a mobile phone or server, to perform various functions) and
(c) hardware circuit(s) and/or processor(s), such as microprocessor(s) or a portion of a microprocessor(s), that requires software (e.g. firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in a server, a cellular network device, or other computing or network device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A frequency digital-to-analogue converter, FDAC, (315, 415) for generating an analogue frequency modulating signal (320, 420) from a digital frequency modulating signal (100, 421); wherein the FDAC comprises a Least Significant Bit, LSB, DAC section (440) and a Most Significant Bit, MSB, DAC section (460); and wherein the LSB DAC section comprises a plurality of LSB DACs (441, 442, 443) and is configured to switch (445, 458) between the LSB DACs for mitigating mismatch; and wherein the MSB DAC section (460) comprises a plurality of MSB DAC cells and is configured to switch (465) the MSB DAC cells according to a predefined sequence during a period (200) of the digital frequency modulating signal.

2. The FDAC (315, 415) according to claim 1 wherein at least one LSB DAC (441) comprises a plurality of binary weighted DAC cells (451-453).

3. The FDAC (315, 415) according to claim 1 or 2 further comprising circuitry (445) configured to randomly select (446, 458) one of the LSB DACs (441, 442, 443) for mitigating the mismatch.

4. The FAC (315, 415) according to any one of the preceding claims wherein the LSB DAC section (440) is further configured to perform the switching (445, 458) at least once per change (602, 603) of an MSB of the digital frequency modulating signal.

5. The FDAC (315, 415) according to any one of the preceding claims wherein the MSB DAC section (460) is further configured to select different sequences for consecutive periods of the frequency modulating signal.

6. The FDAC (315, 415) according to any one of the preceding claims wherein the MSB DAC section (460) is further configured to activate or deactivate (474-476) the MSB DAC cells incrementally according to the predefined sequence when presented with respectively increasing or decreasing MSBs.

7. The FDAC (315, 415) according to any one of the preceding claims wherein the digital frequency modulating signal is a sawtooth wave (200) or a triangle wave.

8. The FDAC (315, 415) according to any one of the preceding claims wherein the MSBs 466 of the digital frequency modulating signal (100, 421) are thermometer coded.

9. A signal generator (301) for generating a Frequency-Modulated Continuous-Wave, FMCW, radar signal (102, 302) comprising:
- an FDAC (315, 415) according to any one of the preceding claims for generating an analogue frequency modulating signal (320, 420); and
- an oscillator (301) controlled by the analogue frequency modulating signal configured to generate the Frequency-Modulated Continuous-Wave, FMCW, radar signal

10. The signal generator (301) according to claim 7 further comprising a circuitry (316) for generating the digital frequency modulating signal.

11. A continuous-wave radar comprising an FDAC according to any one of claims 1 to 8 or the signal generator according to claim 9 or 10.

12. A method for generating an analogue frequency modulating signal (320, 420) from a digital frequency modulating signal (100, 421) comprising the following steps:
- converting Least Significant Bits, LSBs, of the digital frequency modulating signal by one of a plurality of LSB DACs (441, 442, 443);
- switching between the LSB DACs for mitigating mismatch;
- converting the Most Significant Bits, MSBs, of the digital frequency modulating signal by MSB DAC cells (441, 442, 443);
- switching the MSB DAC cells according to a predefined sequence during a period of the digital frequency modulating signal.
